# EUROPÄISCHE PATENTSCHRIFT

(11) **EP 1 166 441 B1**
(45) Veröffentlichungstag und Bekanntmachung des Hinweises auf die Patenterteilung: **02.06.2004**
(21) Anmeldenummer: 00920366.2
(22) Anmeldetag: 01.03.2000
(51) Int. Cl.: H03H 9/02

(54) **STEHENDE WELLEN VERWENDENDES BAUELEMENT MIT PIEZOELEKTRISCHER SCHICHT**
COMPONENT USING STANDING WAVES WITH PIEZOELECTRIC LAYER
COMPOSANT A ONDE STATIONAIRE AVEC COUCHE PIEZOELECTRIQUE

(30) Priorität: 30.03.1999 DE 19914468
(43) Veröffentlichungstag der Anmeldung: 02.01.2002
(73) Patentinhaber: Infineon Technologies AG, 81669 München (DE); Nokia Corporation, 02150 Espoo (FI)
(72) Erfinder: AIGNER, Robert, D-81675 München (DE); ELLA, Juha, FIN-24800 Halikko (FI)
(74) Vertreter: Epping Hermann & Fischer
(86) Internationale Anmeldenummer: PCT/DE2000/000640
(87) Internationale Veröffentlichungsnummer: WO 2000/060737

(56) Entgegenhaltungen:
- DE-B- 1 200 890
- FR-A- 2 191 355
- US-A- 4 571 519

## Beschreibung

Die Erfindung betrifft ein Bauelement, das für Hochfrequenzanwendungen geeignet ist.

In Hochfrequenzanwendungen werden einerseits auf Masse bezogene Signale, die in der Fachliteratur meist als Single ended bezeichnet werden, und andererseits differentielle Signale, die in der Fachliteratur meist als Balanced signals bezeichnet werden, verwendet. Auf Masse bezogene Signale sind empfindlich auf Schwankungen des Massepotentials. Differentielle Signale, die vorzugsweise symmetrisch zum Massepotential sind, sind dagegen unempfindlich gegen Verschiebungen des Massepotentials.

In bestimmten Hochfrequenzanwendungen, zum Beispiel zwischen einer Antenne und einer ersten Verstärkerstufe einer mobilen Kommunikationseinrichtung, werden auf Masse bezogene Signale verwendet, die nachfolgend gefiltert und in differentielle Signale umgewandelt werden. Vielfach ist zusätzlich eine Impedanzanpassung erforderlich.

Als Filter für Hochfrequenzsignale werden vielfach Resonatoren verwendet, die eine piezoelektrische Schicht aufweisen, die zwischen zwei Elektroden angeordnet ist (siehe zum Beispiel K. M. Lakin et al, IEEE MTT-S International 1995, Seiten 883 bis 886, K. M. Lakin et al, IEEE Trans. Microwave Theory Techn., Vol. 41, Nr. 12, 1993, Seiten 2139 bis 2146 und W. W. Lau et al, 1996 IEEE Int. Frequency Control Symp., Seiten 558 bis 562). Wird das Hochfrequenzsignal an die beiden Elektroden angelegt, so wird in der piezoelektrischen Schicht eine mechanische Schwingung angeregt. Für eine Wellenlänge, die der doppelten Dicke der piezoelektrischen Schicht entspricht, bildet sich eine stehende Welle aus. Die Frequenzselektivität der Impedanz eines solchen Resonators kann zur Filterung von Signalen verwendet werden.

Es sind unterschiedliche Bauarten derartiger Resonatoren vorgeschlagen worden (siehe K. M. Lakin et al, IEEE MTT-S International 1995, Seiten 883 bis 886). Zum einen wird der Resonator nur am Rand auf einem Träger befestigt, während der aktive Resonatorteil an der Oberfläche einer Membran oberhalb eines Hohlraums angeordnet ist. Desweiteren ist vorgeschlagen worden, den aktiven Resonatorteil durch einen Luftspalt von einem Substrat zu isolieren, mit dem der Resonator am Rand befestigt ist. Schließlich ist vorgeschlagen worden, den Resonator oberhalb einer Schichtenfolge, die die Wellenlänge, die der Resonator verstärkt, reflektiert, anzuordnen. In diesem Fall ist der Resonator über seine volle Breite mit der Unterlage verbunden. Die Schichtenfolge weist mehrere λ/4 Schichten auf und wirkt als akustischer Spiegel. Der Platzbedarf dieser Resonatoren beträgt typisch 200 µm x 200µm.

Diese Resonatoren weisen zwei Elektroden auf, das heißt, es handelt sich um Eintor-Anordnungen, die in der Fachliteratur vielfach als One Port device bezeichnet werden.

In K. M. Lakin et al, IEEE Trans. Microwave Theory Techn., Vol. 41, Nr. 12, 1993, Seiten 2139 bis 2146, ist eine Zweitoranordnung vorgeschlagen worden, die beiderseits eines Substrats jeweils eine zwischen zwei Elektroden angeordnete piezoelektrische Schicht aufweist. Eine weitere Zweitoranordnung eines Resonators weist auf einem Substrat zwei übereinander gestapelte Filter auf. Dazu ist auf dem Substrat eine floatende Elektrode, darauf eine erste piezoelektrische Schicht, darauf eine geerdete Elektrode, darauf eine zweite piezoelektrische Schicht und darauf zwei nebeneinander angeordnete Elektroden vorgesehen. Diese Anordnung weist eine hohe Einfügedämpfung auf, obwohl gestapelte Filter als Eintoranordnung eine hohe Sperrbanddämpfung aufweisen. Wegen der erforderlichen zwei piezoelektrischen Schichten in den Zweitoranordnungen sind diese im Vergleich zu den Eintoranordnungen mit einem erhöhten Aufwand verbunden.

Das Dokument DE-A-1 200 890 beschreibt einen Biegeschwinger aus elektrostriktivem Material für eine Eintor-Anwendung. Das Dokument FR-A-2 191 355 beschreibt ein piezoelektrisches Filter welches die Anregung von Scherwellen verwendet.

Eine andere Möglichkeit, Hochfrequenzsignale zu filtern, besteht in der Anwendung von Oberflächenwellenfiltern, bei denen zwei Elektroden an der Oberfläche eines Substrats aus piezoelektrischem Material (Quarz, Lithium - Niobat) angeordnet sind. Über diese Elektroden werden Oberflächenwellen angeregt, die sich in der Oberfläche des Substrats ausbreiten. übliche Abmessungen von Oberflächenwellenfiltern liegen bei 2 x 3 mm².

Der Erfindung liegt das Problem zugrunde, ein Bauelement anzugeben, das für Hochfrequenzanwendungen geeignet ist und das als Mehrtoranordnung mit geringem Flächenbedarf und geringem Aufwand realisierbar ist.

Dieses Problem wird gelöst durch ein Bauelement gemäß Anspruch 1. Weitere Ausgestaltungen der Erfindung gehen aus den weiteren Ansprüchen hervor.

Das Bauelement weist eine piezoelektrische Schicht mit einem ersten Elektrodenpaar und einem zweiten Elektrodenpaar auf. Dabei weist das erste Elektrodenpaar eine erste untere Elektrode und eine erste obere Elektrode auf. Das zweite Elektrodenpaar weist eine zweite untere Elektrode und eine zweite obere Elektrode auf. Die erste obere Elektrode und die zweite obere Elektrode sind dabei an einer ersten Hauptfläche der piezoelektrischen Schicht angeordnet. Die erste' untere Elektrode und die zweite untere Elektrode sind an einer zweiten Hauptfläche der piezoelektrischen Schicht angeordnet, die der ersten Hauptfläche gegenüberliegt. Die erste obere Elektrode, die zweite obere Elektrode, die erste untere Elektrode und die zweite untere Elektrode sind dabei jeweils strukturiert, wobei die Strukturen der ersten oberen Elektrode und die Strukturen der zweiten oberen Elektrode sowie die Strukturen der ersten unteren Elektrode und die Strukturen der zweiten unteren Elektrode jeweils ineinandergreifen. Das heißt mit anderen Worten, Strukturen der ersten oberen Elektrode und der zweiten oberen Elektrode sowie der ersten unteren Elektrode und der zweiten unteren Elektrode sind jeweils nebeneinander, vorzugsweise alternierend, angeordnet.

Wird zum Beispiel an das erste Elektrodepaar ein Hochfrequenzsignal angelegt, so bewirkt dieses eine mechanische Schwingung der piezoelektrischen Schicht. Die mechanische Schwingung bildet sich in der gesamten piezoelektrischen Schicht aus, auch in den Bereichen, in denen zwischen benachbarten Strukturen der ersten oberen Elektrode bzw. der ersten unteren Elektrode die Oberfläche der piezoelektrischen Schicht nicht mit der jeweiligen Elektrode belegt ist. Über den sogenannten inversen Piezoeffekt erzeugt diese mechanische Schwingung zwischen der zweiten unteren Elektrode und der zweiten oberen Elektrode des zweiten Elektrodenpaars ein Hochfrequenzsignal.

Vorzugsweise sind die Strukturen der ersten oberen Elektrode, der zweiten oberen Elektrode, der ersten unteren Elektrode und der zweiten unteren Elektrode in einer Dimension so fein, daß sie Abmessungen aufweisen, die kleiner sind als die Wellenlänge einer mechanischen Schwingung, die sich bei Anliegen eines Hochfrequenzsignals an dem ersten Elektrödenpaar zwischen der ersten oberen Elektrode und der zweiten oberen Elektrode einerseits und der ersten unteren Elektrode und der zweiten unteren Elektrode andererseits ausbildet.

Gemäß einer bevorzugten Ausführungsform sind die Strukturen der ersten oberen Elektrode, der zweiten oberen Elektrode, der ersten unteren Elektrode und der zweiten unteren Elektrode in einer Dimension so fein, daß sie Abmessungen aufweisen, die kleiner sind als das Doppelte des Abstands zwischen den oberen Elektroden und den unteren Elektroden. Das bedeutet, daß diese Abmessungen kleiner sind als die Wellenlänge eines Hochfrequenzsignals, für das sich in dem Schichtstapel eine stehende Welle ausbildet und für das somit die Resonanzbedingung erfüllt ist.

Sind die Strukturen des ersten Elektrodenpaares feiner als die Resonanzwellenlänge, so ist der Einfluß dieser Strukturen auf die mechanische Schwingung, die sich bei Anlegen eines Hochfrequenzsignals an das erste Elektrodenpaar in der gesamten piezoelektrischen Schicht ausbildet, reduziert. Die piezoelektrische Schicht "sieht" aufgrund der Abmessungen diese Strukturen nicht. Über den sogenannten inversen Piezoeffekt erzeugt diese mechanische Schwingung zwischen der zweiten unteren Elektrode und der zweiten oberen Elektrode'des zweiten Elektrodenpaars ein Hochfrequenzsignal.

Das an das erste Elektrodenpaar angelegte Hochfrequenzsignal und das am zweiten Elektrodenpaar induzierte Hochfrequenzsignal sind voneinander galvanisch entkoppelt. Die erste untere Elektrode und die erste obere Elektrode sowie die zweite untere Elektrode und die zweite obere Elektrode können somit unabhängig voneinander beschaltet werden. Insbesondere erlaubt das Bauelement die Umwandlung eines auf Masse bezogenen Signals in ein differentielles Signal. Dazu wird die erste untere Elektrode oder die erste obere Elektrode des ersten Elektrodenpaares auf Massepotential gelegt, während die andere Elektrode des ersten Elektrodenpaares mit dem Hochfrequenzsignal beaufschlagt wird. Die zweite obere Elektrode und die zweite untere Elektrode des zweiten Elektrodenpaares werden dagegen symmetrisch zum Massepotential gelegt. Auf diese Weise wird das auf Masse bezogene Eingangssignal in ein differentielles Signal am zweiten Elektrodenpaar verwandelt.

Das Bauelement bewirkt somit gleichzeitig eine Filterung des Eingangssignals und eine Transformation des Eingangssignals. Über die Fläche, die die erste obere Elektrode, die erste untere Elektrode bzw. die zweite obere Elektrode und die zweite untere Elektrode belegen, läßt sich darüber hinaus eine Impedanzanpassung zwischen unterschiedlichen Impedanzniveaus in einem System vornehmen. Im Hinblick auf eine Impedanzanpassung ist es daher vorteilhaft, das erste Elektrodenpaar und das zweite Elektrodenpaar mit unterschiedlich großen Flächen parallel zur piezoelektrischen Schicht vorzusehen. Bei der Verwendung des Bauelementes können somit sowohl eine Filterfunktion als auch eine Transformation und eine Impedanzanpassung gleichzeitig realisiert werden. Im Vergleich zu den bekannten Lösungen, bei denen zur Filterung, Impedanzanpassung und Transformation mehrere Komponenten, gegebenenfalls komplexe Schaltungsnetzwerke erforderlich sind, bedeutet dieses eine Platz- und Aufwandsersparnis.

Vorzugsweise sind die Abmessungen der Strukturen in der einen Dimension mindestens um einen Faktor 3 kleiner als die doppelte Dicke der dielektrischen Schicht. Je kleiner die Abmessungen der Strukturen sind, desto weniger beeinflussen diese Strukturen die sich ausbildenden mechanischen Schwingungen bzw. das induzierte Hochfrequenzsignal.

Die piezoelektrische Schicht mit dem ersten Elektrodenpaar und dem zweiten Elektrodenpaar kann sowohl an der Oberfläche einer Membran, die einen Hohlraum in einem Trägerrahmen überspannt, befestigt sein, als auch über einen Luftspalt von einem Substrat isoliert sein, mit dem sie verbunden ist, als auch oberhalb von akustischen Spiegelschichten, die eine Ausbreitung der mechanischen Schwingung in ein darunter angeordnetes Substrat verhindern, realisiert sein.

Die Dicke der piezoelektrischen Schicht wird so bemessen, daß sich in der piezoelektrischen Schicht und den benachbarten Elektroden oder in der piezoelektrischen Schicht, einer benachbarten Schicht, zum Beispiel einer Spiegelschicht, und den Elektroden im Betrieb des Bauelementes eine stehende Welle mit einer Wellenlänge λ ausbildet. In der Regel beträgt die Dicke der piezoelektrischen Schicht λ/2 oder ganzzahlige Vielfache davon. Falls sich die stehende Welle in der piezoelektrischen Schicht und einer benachbarten Schicht ausbildet, beträgt die Dicke der piezoelektrischen Schicht λ/4 oder ungeradzahlige Vielfache davon.

Vorzugsweise weist die piezoelektrische Schicht mindestens eines der Materialien AlN, ZnO, PdZrTiOₓ (PZT) oder jedes andere Dünnfilmpiezomaterial auf. In diesem Fall beträgt die Dicke der piezoelektrischen Schicht zwischen 1 µm und 3 µm. Das Bauelement ist somit als Filter für einen Frequenzbereich zwischen 400 MHz und 4GRz geeignet. In diesem Fall weisen die Elektroden minimale Abmessungen zwischen 5 µm und 1 µm auf.

Gemäß einer Ausgestaltung der Erfindung weisen die erste obere Elektrode, die erste untere Elektrode, die zweite obere Elektrode und die zweite untere Elektrode jeweils einen Steg auf, an den Teilstrukturen angrenzen, die mit dem Steg verbunden sind. Dabei sind die erste obere Elektrode und die zweite obere Elektrode sowie die erste untere Elektrode und die zweite untere Elektrode so zueinander angeordnet, daß die Teilstrukturen der ersten oberen Elektrode und die Teilstrukturen der zweiten oberen Elektrode bzw. die Teilstrukturen der ersten unteren Elektrode und die Teilstrukturen der zweiten unteren Elektrode alternierend angeordnet sind.

Die Teilstrukturen können insbesondere fingerförmig ausgebildet sein, so daß die jeweilige Elektrode eine kammförmige Form aufweist und die erste obere Elektrode und die zweite untere Elektrode interdigitäl angeordnet sind.

Alternativ können die verästelt oder bäumförmig ausgebildet sein. Dabei können sich die Teilstrukturen der oberen Elektrode von den Teilstrukturen der unteren Elektrode unterscheiden, wobei zwischen den Teilstrukturen der oberen Elektrode und den Teilstrukturen der unteren Elektrode überlappende Bereiche existieren.

Zur wirksamen Unterdrückung lateraler Moden bei der Anregung der mechanischen Schwingung ist es vorteilhaft, die Abmessungen und Abstände zwischen den Teilstrukturen in dem Bauelement unterschiedlich zu gestalten, wobei die Abmessungen und Abstände jeweils um einen Mittelwert variieren. Insbesondere ist es möglich, die Form der Teilstrukturen so zu variieren, daß deren Kontur keine rechten Winkel aufweist.

Die Stege der ersten oberen Elektrode und der zweiten oberen Elektrode können parallel zu den Stegen der ersten unteren Elektrode und der zweiten unteren Elektrode ausgerichtet sein. Alternativ sind die Stege der oberen Elektroden gegenüber den Stegen der unteren Elektroden rotiert. Dieses hat den Vorteil, daß der Einfluß der Strukturierung der einzelnen Elektroden auf die sich ausbildenden mechanischen Schwingungen weiter reduziert ist.

Darüber hinaus können die oberen Elektroden anders strukturiert sein als die unteren Elektroden. Dieser Unterschied kann sich sowohl auf die Form der Strukturierung als auch auf die Abmessungen der Strukturierung beziehen.

Im folgenden wird die Erfindung anhand von Ausführungsbeispielen, die in den Figuren dargestellt sind, näher erläutert. Die Darstellungen sind nicht maßstäblich.
- Figur 1: zeigt einen Schnitt durch ein erfindungsgemäßes Bauelement.
- Figur 2: zeigt den in Figur 1 mit II-II bezeichneten Schnitt durch das Bauelement, der in Figur 1 dargestellte Schnitt-ist mit I-I bezeichnet.
- Figur 3: zeigt eine Aufsicht auf das erfindungsgemäße Bauelement.
- Figur 4 und Figur 5: zeigen Details der Struktur der ersten oberen Elektrode und der zweiten oberen Elektrode bzw. der zugehörigen ersten unteren Elektrode und zweiten unteren Elektrode.
- Figur 6 und Figur 7: zeigen die Struktur einer ersten oberen Elektrode und einer zweiten oberen Elektrode bzw. der zugehörigen ersten unteren Elektrode und der zweiten Elektrode.
- Figur 8 und Figur 9: zeigen unterschiedliche Strukturierungen für obere oder untere Elektroden.

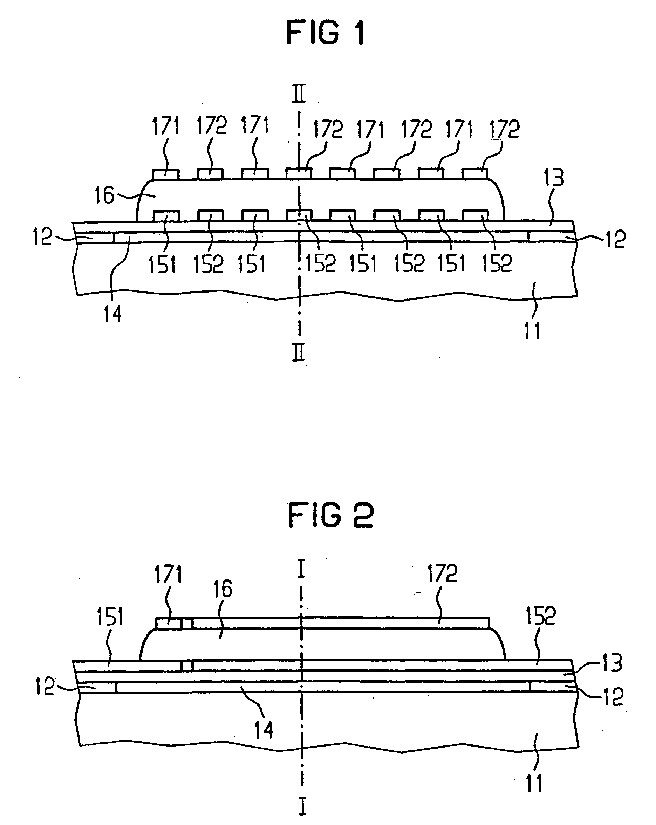

Auf einem Substrat 11 aus monokristallinem Silizium ist über eine Trägerstruktur 12 aus Siliziumoxid eine Membran 13 aus Polysilizium befestigt (siehe Figur 1 und Figur 2). Zwischen dem Substrat 11 und der Membran 13 wird dabei ein Hohlraum 14 aufgespannt, der ein Volumen von 200 µm x 200 µm x 1 µm aufweist. Die Dicke der Membran 13 beträgt 0,4 µm.

An der Oberfläche der Membran 13 sind eine erste untere Elektrode 151 aus Metall, zum Beispiel Aluminium, und eine zweite untere Elektrode 152 aus Metall, zum Beispiel Aluminium, angeordnet. Oberhalb der ersten unteren Elektrode 151 und der zweiten unteren Elektrode 152 ist eine piezoelektrische Schicht 16 aus AlN, ZnO oder PbZrTiO (PZT) in einer Dicke von 2 µm angeordnet. Oberhalb der piezoelektrischen Schicht 16 sind eine erste obere Elektrode 171 aus Metall, zum Beispiel Aluminium, und eine zweite obere Elektrode 172 aus Metall, zum Beispiel Aluminium, angeordnet.

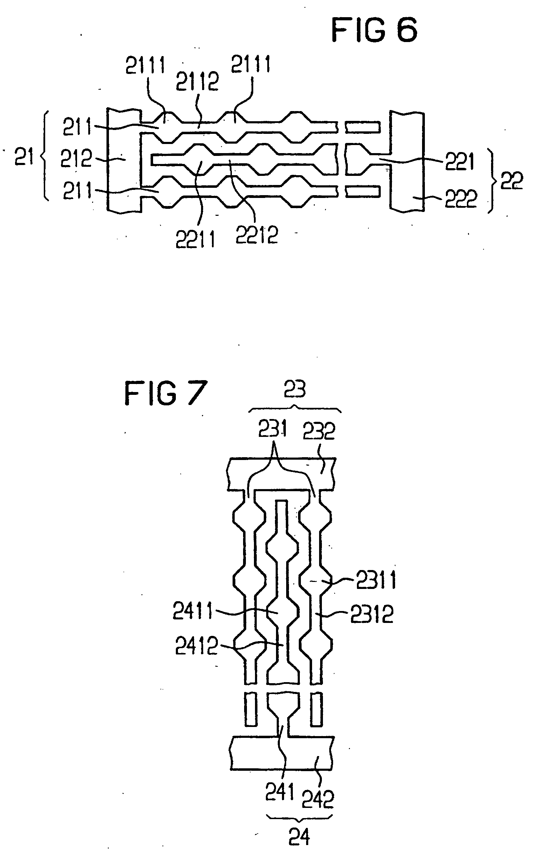

Die erste untere Elektrode 151 und die zweite untere Elektrode 152 weisen jeweils fingerförmige Teilstrukturen 1511, 1521 auf, die alternierend angeordnet sind, das heißt, jeweils im Wechsel ist eine fingerförmige Teilstruktur 1511 der ersten unteren Elektrode 151 und eine fingerförmige Teilstruktur 1521 der zweiten unteren Elektrode 152 angeordnet (siehe Figur 5). Am Rand des Hohlraums 14 weisen sowohl die erste untere Elektrode 151 als auch die zweite untere Elektrode 152 jeweils einen Steg 1512, 1522 auf, über den die fingerförmigen Teilstrukturen 1511, 1521 miteinander verbunden sind. Die Stege 1512, 1522 der ersten unteren Elektrode 151 und der zweiten unteren Elektrode 152 sind an einander gegenüberliegenden Seiten des Hohlraums 14 angeordnet. Die fingerförmigen Teilstrukturen 1511 der ersten unteren Elektrode 151 weisen einen Abstand von 3 µm und einen rechteckigen Querschnitt mit einer Breite von 1 µm und einer Länge von 200 µm auf. Sie sind untereinander parallel angeordnet. Die Längsrichtung der fingerförmigen Teilstrukturen 1511 ist senkrecht zur Längsausrichtung des Steges 1512 angeordnet. Die Abmessungen gelten entsprechend für die Teilstrukturen 1521 der zweiten unteren Elektrode 152. Die Dicke der ersten unteren Elektrode 151 und der zweiten unteren Elektrode 152 beträgt 0,4 µm. Die piezoelektrische Schicht 16 überdeckt mindestens die fingerförmigen Teilstrukturen 1511, 1521 der ersten unteren Elektrode 151 und der zweiten unteren Elektrode 152.

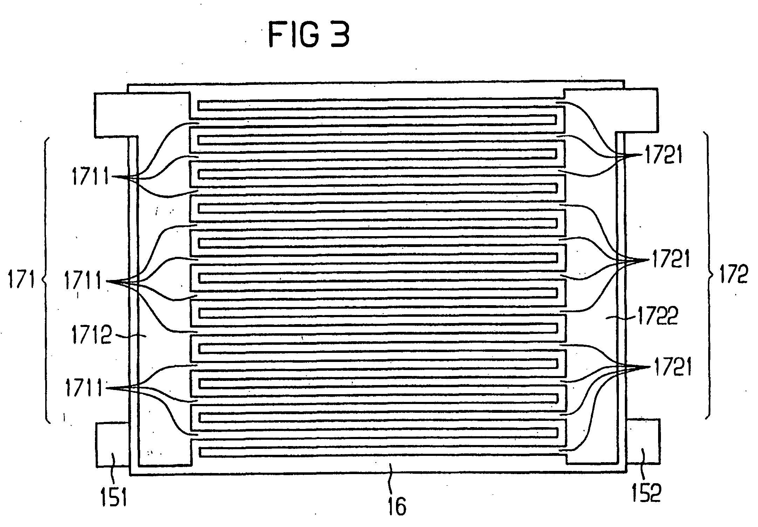

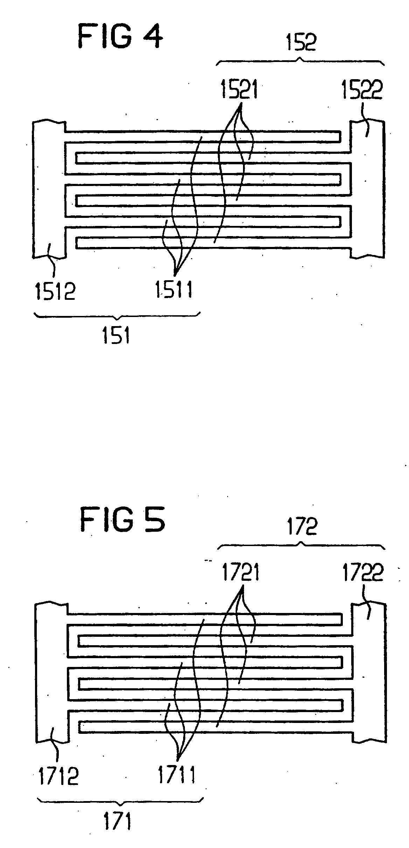

Die erste obere Elektrode 171 und die zweite obere Elektrode 172 sind analog wie die erste untere Elektrode 151 und die zweite untere Elektrode 152 strukturiert. Sie weisen jeweils fingerförmige Teilstrukturen 1711, 1721 auf, die über einen Steg 1712, 1722 miteinander verbunden sind (siehe Figur 3 und Figur 4). Im Bereich oberhalb des Hohlraums 14 sind alternierend eine fingerförmige Teilstruktur 1711 der ersten oberen Elektrode 171 und eine fingerförmige Teilstruktur 1721 der zweiten oberen Elektrode 172 angeordnet (siehe Figur 2 und Figur 3). Die Stege 1712, 1722 der ersten oberen Elektrode 171 und der zweiten oberen Elektrode 172 sind oberhalb einander entgegensetzter Ränder des Hohlraums 14 angeordnet. Die Stege 1712, 1722 der ersten oberen Elektrode 171 und der zweiten oberen Elektrode 172 verlaufen parallel den Stegen 1512, 1522 der ersten unteren Elektrode 151 und der zweiten unteren Elektrode 152(siehe Figur 4 und Figur 5).

Die erste obere Elektrode 171 und die erste untere Elektrode 151 bilden eines erstes Elektrodenpaar, die zweite obere Elektrode 172 und die zweite untere Elektrode 152 bilden ein zweites Elektrodenpaar. Im Betrieb des Bauelementes wird das erste Elektrodenpaar mit einem Eingangssignal beaufschlagt, das in der piezoelektrischen Schicht eine mechanische Schwingung anregt. Diese mechanische Schwingung induziert in dem zweiten Elektrodenpaar ein Ausgangssignal.

Ist das Eingangssignal ein auf Masse bezogenes Signal (Single ended signal), so wird die erste untere Elektrode 151 auf Massepotential gelegt und die erste obere Elektrode 171 auf das auf Masse bezogene Signal. Zwischen der zweiten unteren Elektrode 152 und der zweiten oberen Elektrode 172 kann dann ein differentielles Signal (Balanced signal) abgegriffen werden, das bezüglich des Massepotentials symmetrisch sein kann.

In einem weiteren Ausführungsbeispiel ist ein Bauelement, mit einer ersten oberen Elektrode 21, einer zweiten oberen Elektrode 22, einer ersten unteren Elektrode 23 und einer zweiten unteren Elektrode 24 versehen, deren Struktur und gegenseitige Anordnung im folgenden anhand von Figur 6 und Figur 7 erläutert wird. Der Aufbau des Bauelementes entspricht im übrigen dem aufbau des anhand von Figur 1 bis Figur 5 ge'schilderten Bauelementes. Die erste obere Elektrode 21 und die zweite obere Elektrode 22 weisen jeweils fingerförmige Teilstrukturen 211, 221 auf, die über einen Steg 212, 222 miteinander verbunden sind. Die erste untere Elektrode 23 und die zweite untere Elektrode 24 weisen ebenfalls fingerförmige Teilstrukturen 231, 241 auf, die jeweils über einen Steg 232, 242 miteinander verbunden sind.

Die fingerförmigen Teilstrukturen 211, 221, 231, 241 der ersten oberen Elektrode 21 und der zweiten oberen Elektrode 22 sowie der ersten unteren Elektrode 23 und der zweiten unteren Elektrode 24 weisen jeweils einen Querschnitt auf, der alternierend rhombusförmige Teile 2111, 2211, 2311, 2411 und stegförmige Teile 2112, 2212, 2312, 2412 enthält.

Die fingerförmigen Teilstrukturen 211, 221 der ersten oberen Elektrode 21 und der zweiten oberen Elektrode 22 sind gegenüber den fingerförmigen Teilstrukturen 231, 241 der ersten unteren Elektrode 23 und der zweiten unteren Elektrode 24 um 90° gedreht, so daß die Projektion der Stege 212, 222 der ersten oberen Elektrode 21 und der zweiten oberen Elektrode 22 auf die Stege 232, 242 der ersten unteren Elektrode 23 und der zweiten unteren Elektrode 24 diese unter 90° schneiden. Entsprechend sind die fingerförmigen Teilstrukturen 231, 241 der ersten unteren Elektrode 23 und der zweiten unteren Elektrode 24 um 90° gegenüber den fingerförmigen Teilstrukturen 211, 221 der ersten oberen Elektrode 21 und der zweiten oberen Elektrode 22 verdreht. Die fingerförmigen Teilstrukturen 211 der ersten oberen Elektrode 21 und die fingerförmigen Teilstrukturen 231 der ersten unteren Elektrode 23 sind so zueinander angeordnet, daß sich deren rhombusförmigen Teile 2111, 2311 überlappen. Entsprechend sind die fingerförmigen Teilstrukturen 221 der zweiten oberen Elektrode 22 und die fingerförmigen Teilstrukturen 241 der zweiten unteren Elektrode 24 sind so zueinander angeordnet, daß sich deren rhombusförmigen Teile 2211, 2411 überlappen.

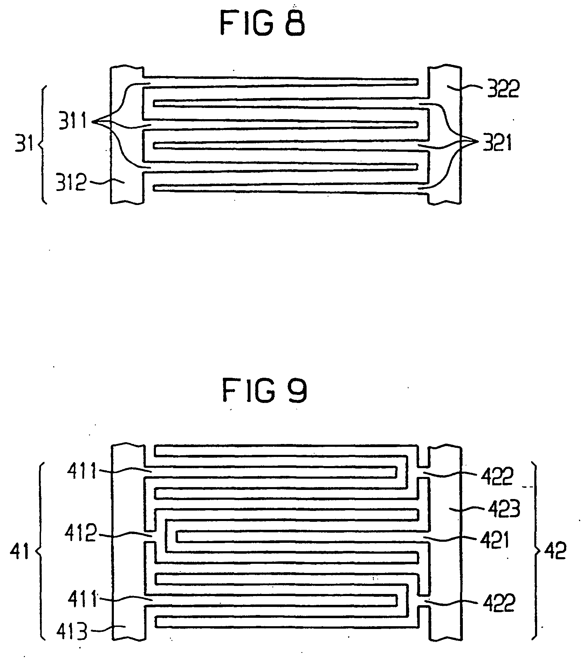

In einer weiteren Elektrodenkonfiguration, die sowohl für untere als auch für obere Elektroden geeignet ist, weisen eine erste Elektrode 31 und eine zweite Elektrode 32 jeweils fingerförmige Teilstrukturen 311, 321 auf, die einen trapezförmigen Grundriß aufweisen (siehe Figur 8). Dabei unterscheiden sich die Abmessungen der einzelnen fingerförmigen Teilstrukturen 311, 321 so, daß diese Abmessungen um einen Mittelwert variieren. Die fingerförmigen Teilstrukturen 311, 321 sind jeweils über einen Steg 312, 322 untereinander miteinander verbunden. Der trapezförmige Querschnitt der fingerförmigen Teilstrukturen 311, 321 sowie deren streuende Abmessungen bewirken, daß sich ausbildende, laterale Moden keine stehenden Wellen verursachen. In einer Anordnung, die trapezförmige fingerförmige Teilstrukturen in oberen und unteren Elektroden aufweist, können diese sowohl parallel zueinander ausgerichtet als auch gegeneinander verdreht sein.

Eine weitere Elektrodenkonfiguration, die sowohl für obere Elektroden als auch für untere Elektroden einsetzbar ist, weist eine erste Elektrode 41 und eine zweite Elektrode 42 auf, die jeweils alternierend eine rechteckige Teilstruktur 411, 421 und eine U-förmig verästelte Teilstruktur 412, 422 aufweisen (siehe Figur 9). Die rechteckigen Teilstrukturen 411, 421 und die U-förmig verästelten Teilstrukturen 412, 422 sind dabei über einen Steg 413, 423 untereinander miteinander verbunden. Dabei weisen die U-förmig verästelten Teilstrukturen 412, 422 jeweils zwei Schenkel auf, die parallel zu den rechteckigen Teilstrukturen 411 ausgerichtet sind. Die rechteckigen Teilstrukturen 411 der ersten Elektrode 41 ragen dabei zwischen die Schenkel der U-förmig verästelten Teilstrukturen 422 der zweiten Elektrode 42 hinein. Umgekehrt ragen die rechteckigen Teilstrukturen 421 der zweiten Elektrode 42 zwischen die Schenkel der U-förmig verästelten Teilstrukturen 412 der ersten Elektrode 41 hinein. Diese Elektrodenkonfiguration ist sowohl für obere als auch für untere Elektroden geeignet, wobei die Teilstrukturen in den oberen Elektroden gegenüber den Teilstrukturen in den unteren Elektroden parallel oder verdreht ausgerichtet sein können.

## Patentansprüche

1. Bauelement zur Ausbildung stehender Wellen einer Wellenlänge λ
- mit einer piezoelektrischen Schicht (16), deren Dicke λ/2 oder ein ganzzahliges Vielfaches von λ/2 beträgt,
- mit einem ersten Elektrodenpaar, das eine erste untere Elektrode (151) und eine erste obere Elektrode (171) aufweist, und einem zweiten Elektrodenpaar, das eine zweite untere Elektrode (152) und eine zweite obere Elektrode (172) aufweist,
- bei dem die erste obere Elektrode (171) und die zweite obere Elektrode (172) an einer ersten Hauptfläche der piezoelektrischen Schicht (16) und die erste untere Elektrode (151) und die zweite untere Elektrode (152) an einer zweiten Hauptfläche der piezoelektrischen Schicht (16) angeordnet sind, die der ersten Hauptfläche gegenüberliegt,
- bei dem die erste obere Elektrode (171), die zweite obere Elektrode (172), die erste untere Elektrode (151) und die zweite untere Elektrode (152) jeweils strukturiert sind, wobei die Strukturen der ersten oberen Elektrode (171) und der zweiten oberen Elektrode (172) sowie der ersten unteren Elektrode (151) und der zweiten unteren Elektrode (152) jeweils ineinander greifen.

2. Bauelement nach Anspruch 1,
- bei dem die erste untere Elektrode (23), die zweite untere Elektrode (24), die erste obere Elektrode (21) und die zweite obere Elektrode (22) jeweils einen Steg (212, 222, 232, 242) aufweisen, an den Teilstrukturen (211, 221, 231, 241) angrenzen, die mit dem Steg (212, 222, 232, 242) verbunden sind,
- bei dem die erste obere Elektrode (21) und die zweite obere Elektrode (22) so angeordnet sind, daß die Teilstrukturen der ersten oberen Elektrode (21) und die Teilstrukturen der zweiten oberen Elektrode (22) alternierend angeordnet sind,
- bei dem die erste untere Elektrode (23) und die zweite untere Elektrode (24) so angeordnet sind, daß die Teilstrukturen (231) der ersten unteren Elektrode (23) und die Teilstrukturen (241) der zweiten unteren Elektrode (24) alternierend angeordnet sind.

3. Bauelement nach Anspruch 2,
bei dem benachbarte Teilstrukturen (211, 221, 231, 241) voneinander einen Abstand aufweisen, der kleiner ist als der doppelte Abstand zwischen der ersten oberen Elektrode (171) und der ersten unteren Elektrode (151), und kleiner als der doppelte Abstand der zweiten oberen Elektrode (172) und der zweiten unteren Elektrode (152).

4. Bauelement nach Anspruch 3,
bei dem der Abstand benachbarter Teilstrukturen mindestens um einen Faktor 10 kleiner ist als der doppelte Abstand zwischen der ersten oberen Elektrode (171) und der ersten unteren Elektrode (151), und kleiner als der doppelte Abstand der zweiten oberen Elektrode (17.2) und der zweiten unteren Elektrode (152).

5. Bauelement nach einem der Ansprüche 2 bis 4,
bei dem die Teilstrukturen (211, 221) fingerförmig ausgebildet sind.

6. Bauelement nach einem der Ansprüche 2 bis 4,
bei dem die Teilstrukturen (412, 422) mindestens teilweise verästelt sind.

7. Bauelement nach einem der Ansprüche 2 bis 6,
bei dem der Abstand benachbarter Teilstrukturen (311, 321) nicht konstant ist, sondern um einen Mittelwert variiert.

8. Bauelement nach einem der Ansprüche 2 bis 7,
bei dem die Abmessungen der Teilstrukturen (311, 321) nicht konstant sind, sondern jeweils um einen Mittelwert variieren.

9. Bauelement nach einem der Ansprüche 2 bis 8,
- bei dem der Steg (1512) der ersten oberen Elektrode (151) so ausgerichtet ist, daß seine Projektion auf die zweite Hauptfläche den Steg (1712) der ersten unteren Elektrode (171) kreuzt,
- bei dem der Steg (1522) der zweiten oberen Elektrode (152) so ausgerichtet ist, daß seine Projektion auf die zweite Hauptfläche den Steg (172) der zweiten unteren Elektrode (172) kreuzt.

10. Bauelement nach einem der Ansprüche 1 bis 9,
- bei dem die piezoelektrische Schicht (16) mindestens eines der Materialien AlN, ZnO, PbZrTiOₓ (PZT) aufweist,
- bei dem die Dicke der piezoelektrischen Schicht (16) zwischen 1 µm und 3 µm beträgt.

## Claims

1. Component for forming standing waves of a wavelength λ
- with a piezoelectric layer (16), the thickness of which is λ/2 or an integral multiple of λ/2,
- with a first pair of electrodes, which has a first lower electrode (151) and a first upper electrode (171), and a second pair of electrodes, which has a second lower electrode (152) and a second upper electrode (172),
- in which the first upper electrode (171) and the second upper electrode (172) are arranged on a first main surface of the piezoelectric layer (16) and the first lower electrode (151) and the second lower electrode (152) are arranged on a second main surface of the piezoelectric layer (16), which lies opposite the first main surface,
- in which the first upper electrode (171), the second upper electrode (172), the first lower electrode (151) and the second lower electrode (152) each are structured, the structures of the first upper electrode (171) and of the second upper electrode (172) as well as of the first lower electrode (151) and of the second lower electrode (152) respectively engaging in one another.

2. Component according to Claim 1,
- in which the first lower electrode (23), the second lower electrode (24), the first upper electrode (21) and the second upper electrode (22) each have a ridge (212, 222, 232, 242), adjacent to which are substructures (211, 221, 231, 241), which are connected to the ridge (212, 222, 232, 242),
- in which the first upper electrode (21) and the second upper electrode (22) are arranged in such a way that the substructures of the first upper electrode (21) and the substructures of the second upper electrode (22) are arranged in an alternating manner,
- in which the first lower electrode (23) and the second lower electrode (24) are arranged in such a way that the substructures (231) of the first lower electrode (23) and the substructures (241) of the second lower electrode (24) are arranged in an alternating manner.

3. Component according to Claim 2, in which neighbouring substructures (211, 221, 231, 241) have a spacing from one another which is less than twice the spacing between the first upper electrode (171) and the first lower electrode (151), and less than twice the spacing between the second upper electrode (172) and the second lower electrode (152).

4. Component according to Claim 3, in which the spacing of neighbouring substructures is less by at least a factor of 10 than twice the spacing between the first upper electrode (171) and the first lower electrode (151), and less than twice the spacing between the second upper electrode (172) and the second lower electrode (152).

5. Component according to one of Claims 2 to 4, in which the substructures (211, 221) are designed in the form of fingers.

6. Component according to one of Claims 2 to 4, in which the substructures (412, 422) are at least partially branched.

7. Component according to one of Claims 2 to 6, in which the spacing of neighbouring substructures (311, 321) is not constant, but varies about a mean value.

8. Component according to one of claims 2 to 7, in which the dimensions of the substructures (311, 321) are not constant, but in each case vary about a mean value.

9. Component according to one of Claims 2 to 8,
- in which the ridge (1512) of the first upper electrode (151) is aligned in such a way that its projection onto the second main surface crosses the ridge (1712) of the first lower electrode (171),
- in which the ridge (1522) of the second upper electrode (152) is aligned in such a way that its projection onto the second main surface crosses the ridge (172) of the second lower electrode (172).

10. Component according to one of Claims 1 to 9,
- in which the piezoelectric layer (16) comprises at least one of the materials AlN, ZnO, PbZrTiOₓ (PZT),
- in which the thickness of the piezoelectric layer (16) is between 1 µm and 3 µm.

## Revendications

1. Composant pour former des ondes stationnaires d'une longueur d'onde λ
- comprenant une couche (16) piézoélectrique dont l'épaisseur est de λ/2 ou d'un multiple entier de λ/2,
- comprenant une première paire d'électrodes qui a une première électrode (151) inférieure et une première électrode (171) supérieure, et une deuxième paire d'électrodes qui a une deuxième électrode (152) inférieure et une deuxième électrode (172) supérieure,
- dans lequel la première électrode (171) supérieure et la deuxième électrode (172) supérieure sont disposées sur une première surface principale de la couche (16) piézoélectrique, et la première électrode (151) inférieure et la deuxième électrode (152) inférieure sont disposées sur une deuxième surface principale de la couche (16) piézoélectrique qui est opposée à la première surface principale,
- dans lequel la première électrode (171) supérieure, la deuxième électrode (172) supérieure, la première électrode (151) inférieure et la deuxième électrode (152) inférieure sont structurées respectivement, les structures de la première électrode (171) supérieure et de la deuxième électrode (172) supérieure ainsi que de la première électrode (151) inférieure et de la deuxième électrode (152) inférieure s'interpénétrant respectivement.

2. Composant suivant la revendication 1,
- dans lequel la première électrode (23) inférieure, la deuxième électrode (24) inférieure, la première électrode (21) supérieure et la deuxième électrode (22) supérieure ont respectivement une nervure (212, 222, 232, 242) dont sont voisines des sous-structures (211, 221, 231, 241) qui sont reliées à la nervure (212, 222, 232, 242),
- dans lequel la première électrode (21) supérieure et la deuxième électrode (22) supérieure sont disposées de façon à ce que les sous-structures de la première électrode (21) supérieure et les sous-structures de la deuxième électrode (22) supérieure soient disposées en alternance,
- dans lequel la première électrode (23) inférieure et la deuxième électrode (24) inférieure sont disposées de façon à ce que les sous-structures (231) de la première électrode (23) inférieure et les sous-structures (241) de la deuxième électrode (24) inférieure soient disposées en alternance.

3. Composant suivant la revendication 2,
dans lequel des sous-structures (211, 221, 231, 241) voisines sont à une distance mutuelle qui est inférieure au double de la distance entre la première électrode (171) supérieure et la première électrode (151) inférieure et inférieure au double de la distance entre la deuxième électrode (172) supérieure et la deuxième électrode (152) inférieure.

4. Composant suivant la revendication 3,
dans lequel la distance entre des sous-structures voisines est plus petite d'au moins un facteur de 10 que le double de la distance entre la première électrode (171) supérieure et la première électrode (151) inférieure, et inférieure au double de la distance entre la deuxième électrode (172) supérieure et la deuxième électrode (152) inférieure.

5. Composant suivant l'une des revendications 2 à 4,
dans lequel les sous-structures (211, 221) sont constituées sous la forme de doigts.

6. Composant suivant l'une des revendications 2 à 4,
dans lequel les sous-structures (412, 422) sont ramifiées au moins en partie.

7. Composant suivant l'une des revendications 2 à 6,
dans lequel la distance entre des sous-structures (311, 321) voisines n'est pas constante, mais varie autour d'une valeur moyenne.

8. Composant suivant l'une des revendications 2 à 7,
dans lequel les dimensions des sous-structures (311, 321) ne sont pas constantes mais varient respectivement autour d'une valeur moyenne.

9. Composant suivant l'une des revendications 2 à 8,
- dans lequel la nervure (1512) de la première électrode (151) supérieure est dirigée de façon à ce que sa projection sur la deuxième surface principale croise la nervure (1712) de la première électrode (171) inférieure,
- dans lequel la nervure (1522) de la deuxième électrode (152) supérieure est dirigée de façon à ce que sa projection sur la deuxième surface principale croise la nervure (172) de la deuxième électrode (172) inférieure.

10. Composant suivant l'une des revendications 1 à 9,
- dans lequel la couche (16) piézoélectrique comprend au moins l'un des matériaux AIN, ZnO, PbZrTiOₓ (PZT),
- dans lequel l'épaisseur de la couche (16) piézoélectrique est comprise entre 1 µm et 3 µm.
